Europäisches Patentamt

European Patent Office

Office européen des brevets

(19)

(11) Veröffentlichungsnummer: **0 140 230**
**B1**

# (12) EUROPÄISCHE PATENTSCHRIFT

(45) Veröffentlichungstag der Patentschrift:
**10.01.90**

(51) Int. Cl.⁴: **G 06 K 19/06**

(21) Anmeldenummer: **84112102.3**

(22) Anmeldetag: **09.10.84**

(54) Datenträger mit integriertem Schaltkreis und Verfahren zur Herstellung desselben.

(30) Priorität: **24.10.83 DE 3338597**

(43) Veröffentlichungstag der Anmeldung:
**08.05.85 Patentblatt 85/19**

(45) Bekanntmachung des Hinweises auf die Patenterteilung:
**10.01.90 Patentblatt 90/2**

(84) Benannte Vertragsstaaten:
**AT BE CH DE FR GB IT LI LU NL SE**

(56) Entgegenhaltungen:
EP-A- 0 068 539
EP-A- 0 071 255
DE-A- 2 659 573
DE-U- 8 221 495

(73) Patentinhaber: **GAO Gesellschaft für Automation und Organisation mbH, Euckenstrasse 12, D-8000 München 70 (DE)**

(72) Erfinder: **Hoppe, Joachim, Breisacherstrasse 1, D-8000 München 80 (DE)**
Erfinder: **Haghiri-Tehrani, Yahya, Dipl.-Ing., Winzererstrasse 98, D-8000 München 40 (DE)**

(74) Vertreter: **Klunker . Schmitt-Nilson . Hirsch, Winzererstrasse 106, D-8000 München 40 (DE)**

## Beschreibung

Die Erfindung betrifft einen mehrschichtigen Datenträger, bestehend aus mindestens einer Kernschicht sowie einer oberen und unteren Deckschicht, einen IC-Baustein für die Verarbeitung elektrischer Signale und Kontaktflächen sowie Leiterbahnen zur Verbindung des IC-Bausteins mit externen Geräten, einem flexiblen, folienähnlichen Substrat mit einer Aussparung für den IC-Baustein, wobei IC-Baustein, Kontaktflächen und Leiterbahnen gemeinsam auf einem Substrat angeordnet sind, die Kontaktflächen und Leiterbahnen aus einer dünnen, elektrisch leitenden Beschichtung des Substrats hergestellt sind und das Substrat derart zwischen Kern- und Deckschichten eingelagert ist, daß der IC-Baustein in einer Aussparung der Kernschicht liegt und die Kontaktflächen in wenigstens einer Aussparung der oberen Deckschicht vorliegen. Die Erfindung betrifft auch ein Verfahren zur Herstellung eines mehrschichtigen Datenträgers der obengenannten Art.

Datenträger wie Kredit-, Ausweis- oder Identifikationskarten mit integriertem Schaltkreis werden in zunehmendem Maße im automatischen Waren- und Dienstleistungsverkehr eingesetzt. Die Kommunikation des integrierten Schaltkreises mit entsprechenden Automaten wird dabei am einfachsten über eine galvanische Kontaktierung vorgenommen. Dazu sind auf der Karte leitende Beläge (Kontaktflächen) vorgesehen, die einerseits über Leiterbahnen mit dem Schaltkreis in der Karte verbunden sind und andererseits über einen geeigneten Kontaktkopf die elektrische Verbindung zu einem externen Gerät ermöglichen. Der Schaltkreis selbst ist vorzugsweise in der Mitte der Ausweiskarte angeordnet, während die Kontaktflächen mit der Oberfläche der Karte bündig abschließen. In dieser Ausführung können die Kontaktflächen im täglichen Gebrauch der Karte am einfachsten von Verschmutzungen freigehalten werden.

Von den vielen bereits bekanntgewordenen Ausweiskarten mit integriertem Schaltkreis und galvanischer Kontaktabnahme seien nachfolgend einige genannt.

In der DE-OS 2 659 573 ist der IC-Baustein gemeinsam mit den Leiterbahnen und den Kontaktflächen auf einem flachen, nicht flexiblen Substrat angeordnet. Zum Einbau des Substrats in eine Ausweiskarte wird der IC-Baustein in einer Aussparung der Karte positioniert und die Ränder des flachen Substrats mit der Karte verbunden. Da die Kontaktflächen mit dem Schaltkreis auf dem gleichen Substrat angeordnet sind, liegen sie in der Ausweiskarte in der Ebene des Schaltkreises, also etwa in der Mitte der Karte. Der Zugang zu den Kontaktflächen ist daher nur über Vertiefungen in der Kartenoberfläche möglich. Da sich in diesen Vertiefungen bevorzugt Schmutz ansammelt, werden sie, wie in der DE-OS 2 659 573 vorgeschlagen, mit einem leitenden Material gefüllt, das dann mit der Kartenoberfläche abschließt.

Die mit dem Auffüllen der Kartenaussparungen vorgenommene Erhöhung der Kontaktflächen kann auch von der Kartenherstellung getrennt bereits bei der Herstellung des Trägersubstrats für den Schaltkreis vorgenommen werden. Dazu sei die DE-OS 3 029 667 genannt, in der die Kontaktflächen des Trägersubstrats bzw. Trägerelements vor dem Einbau in eine Karte mit elektrisch leitenden Höckern versehen werden. Bei der Fertigstellung der Karte wird das Trägerelement in ein Fenster dieser Karte eingesetzt und mit einer Deckfolie laminiert, die im Bereich der Höcker Aussparungen aufweist. Die Höhe der leitenden Höcker entspricht der Dicke der Deckfolie, so daß die Kontaktflächen bei der fertigen Karte bündig mit der Kartenoberfläche abschließen.

Ein ähnlicher Vorschlag ist auch aus der EP-A 71 255 bekannt. Bei dieser bekannten Karte wird ein sogenanntes Mikropack-Element als Träger für den integrierten Schaltkreis, die Leiterbahnen und die Kontaktflächen eingesetzt. Damit die Kontaktflächen bei der fertiggestellten Karte mit der Kartenoberfläche abschließen, werden dieselben mit Hilfe zusätzlicher Materialien in der Dicke entsprechend verstärkt. Mit der auf diese Weise vorab am Trägerelement vorgenommenen Überhöhung der Kontaktflächen kann bei der fertigen Karte der IC-Baustein in der Kartenmitte angeordnet werden, während die Kontaktflächen mit der Kartenoberfläche bündig abschließen.

Den genannten Lösungen ist gemeinsam, daß das Anordnen der Kontaktflächen an der Kartenoberfläche zusätzliche Arbeitsgänge und zusätzlichen Materialaufwand erfordert. Außerdem läßt sich bei den bekannten Lösungen durch die Verwendung erhöhter Kontakte eine zusätzliche Übertragungsstelle zwischen den eigentlichen Kontaktflächen des Trägersubstrats und den an der fertigen Karte zugänglichen Kontaktflächen nicht umgehen, womit grundsätzlich eine zusätzliche Gefahrenquelle für Störungen geschaffen wird.

Diese zusätzliche Übergangsstelle kann vermieden werden, wenn, wie in der DE-OS 3 123 198 beschrieben, das Trägerelement verbiegbare, frei über den Rand des Trägers hinausragende Kontaktfahnen aufweist, die beim Zusammenbau der Karte durch Schlitze der Deckfolie geführt und umgeklappt werden. Beim Laminieren der Kartenschichten unter Wärme und Druck werden die Kontaktfahnen in die Deckfolie eingepreßt und schließen bei der fertigen Karte bündig mit der Kartenoberfläche ab. Bei diesem Verfahren ist darauf zu achten, daß die vergleichsweise dünnen Kontaktfahnen nicht knicken, wenn sie durch Schlitze der Deckfolie geführt werden. Das vorgeschlagene Verfahren eignet sich daher weniger für die Herstellung von Ausweiskarten mit integriertem Schaltkreis in großen Serien.

Aus der EP-A 68 539 ist schließlich ein Vorschlag bekannt, bei dem das den integrierten Schaltkreis aufnehmende Trägerelement vor dem Einbau in einer Ausweiskarte derart präpariert wird, daß IC-Baustein und Kontaktflächen, wie oben erwähnt, in der Ausweiskarte plaziert sind.

Bei diesem bekannten Vorschlag ist der integrierte Schaltkreis auf einer Metallplatte befestigt, die den Schaltkreis vor mechanischen Belastungen schützen soll und außerdem der Wärmeableitung dient. Die Anschlußpunkte des Schaltkreises sind mit dünnen Drähten mit gekröpften Kontaktelementen verbunden. Metallplatte und Kontaktelemente werden aus einem metallischen Material gestanzt. Schließlich sind der IC-Baustein und die dünnen empfindlichen Leiterbahnen von einem Harzblock umgeben, der die gesamte Anordnung versteift und damit schützt. Aufgrund der notwendigen Vorbereitungsmaßnahmen am Trägerelement und der damit zwangsläufig verbundenen Kosten wird schließlich auch die Ausweiskarte entsprechend teuer in der Fertigung.

Die Aufgabe der Erfindung besteht nun darin, eine Ausweiskarte mit IC-Baustein vorzuschlagen, bei der die Kontaktflächen an der Kartenoberfläche liegen, während der Baustein selbst etwa in der Kartenmitte lagert. Die Ausweiskarte soll im Gegensatz zu bekannten Karten einfach und damit kostengünstig herstellbar sein, damit sie auch in großen Serien wirtschaftlich gefertigt werden kann. Darüberhinaus sollten Gefahrenquellen, die den Betrieb des IC-Bausteins stören könnten, soweit wie möglich vermieden werden. Weiterhin soll ein Verfahren zur Herstellung einer Ausweiskarte vorgeschlagen werden.

Die Aufgabe wird erfindungsgemäß durch die in den unabhängigen Ansprüchen 1 und 11 angegebenen Merkmale gelöst.

In einer vorteilhaften Ausführungsform der Erfindung ist der IC-Baustein auf einer flexiblen Trägerfolie mit hoher Thermostabilität und hoher Zugfestigkeit, dem Substrat, montiert. Der Schaltkreis ist in einer Aussparung des Substrats mit in die Aussparung hineinragenden Leiterbahnen verbunden. Die Leiterbahnen enden auf dem Substrat in Kontaktflächen, wobei Leiterbahnen und Kontaktflächen aus einer dünnen, elektrisch leitenden Beschichtung des Substrats hergestellt sind. Die Kontaktflächen sind, beispielsweise zusammengefaßt in zwei Gruppen, beidseitig des Schaltkreises auf dem Substrat angeordnet. Die Ausweiskarte besteht aus drei Schichten. Die mittlere Schicht oder Kernschicht ist mit einer dem Schaltkreis angepaßten Aussparung versehen. Die obere Deckschicht hat zwei Aussparungen, die kongruent zu den Abmaßen der Kontaktgruppen gestanzt sind.

Während des Zusammenpressens bzw. Kaschierens der Kartenschichten wird das flexible Substrat, im wesentlichen bedingt durch die Aussparungen in den einzelnen Schichten der Karte, derart verformt, daß bei der fertigen Karte der Baustein geschützt in der Mitte liegt, während die Kontaktflächen bündig mit der Oberfläche der Karte abschließen. Der sehr einfache Kartenaufbau, verbunden mit der Verwendung eines ebenfalls einfachen und kostengünstig herstellbaren Trägerelements, bestehend aus dem Substrat, dem IC-Baustein, den Leiterbahnen und Kontaktflächen, erlaubt die wirtschaftliche Herstellung einer Ausweiskarte mit IC-Bausteinen gerade auch in großen Serien. Der, wie oben ausgeführt, bei den bekannten Ausweiskarten notwendige Materialaufwand und vor allem auch der über die übliche Kartenherstellung zum Teil weit hinausgehende Arbeitsaufwand erübrigt sich bei der erfindungsgemäßen Karte. Außerdem ist dafür gesorgt, daß die Kontaktflächen über Leiterbahnen direkt mit dem Schaltkreis verbunden sind, womit Gefahrenquellen für Störungen, bedingt durch zusätzliche Kontakt- bzw. Verbindungsstellen, vermieden werden.

Weitere vorteilhafte Ausführungsformen der Erfindung sind gekennzeichnet durch unterschiedliche Gestaltung der Aussparungen der oberen Deckfolie bezogen auf die Kontaktbereiche des Trägerelements oder auch durch unterschiedliche Befestigungstechniken des Trägerelements in der Karte.

Nachfolgend werden die Ausführungsformen sowie weitere Vorteile und Weiterbildungen der Erfindung anhand der beiliegenden Zeichnungen näher erläutert.

Es zeigen:

Fig. 1, 2, 3 Ausweiskarten mit eingelagertem IC-Baustein in drei verschiedenen Ausführungsformen,

Fig. 4 die Ausweiskarte gemäß der Fig. 1 mit detaillierter Darstellung des Trägerelements,

Fig. 5 die Ausweiskarte gemäß der Fig. 4 im Schnitt vor dem Zusammenfügen der einzelnen Schichten,

Fig. 6 die fertige Ausweiskarte im Schnitt entlang der Linie 6–6 aus der Fig. 4,

Fig. 7 die fertige Ausweiskarte im Schnitt entlang der Linie 7–7 aus der Fig. 4,

Fig. 8 detaillierte Darstellung eines Trägerelements zum Einbau in eine Ausweiskarte gemäß Fig. 2,

Fig. 9 die Ausweiskarte gemäß der Fig. 2 im Schnitt vor dem Zusammenfügen der einzelnen Schichten,

Fig. 10 die fertige Karte im Schnitt entlang der Linie 10–10 aus Fig. 8,

Fig. 11 detaillierte Darstellung eines Trägerelements zum Einbau in eine Ausweiskarte gemäß Fig. 3,

Fig. 12 die Ausweiskarte gemäß der Fig. 3 im Schnitt vor dem Zusammenfügen der einzelnen Schichten,

Fig. 13 die fertige Ausweiskarte im Schnitt entlang der Linie 13–13 aus Fig. 12.

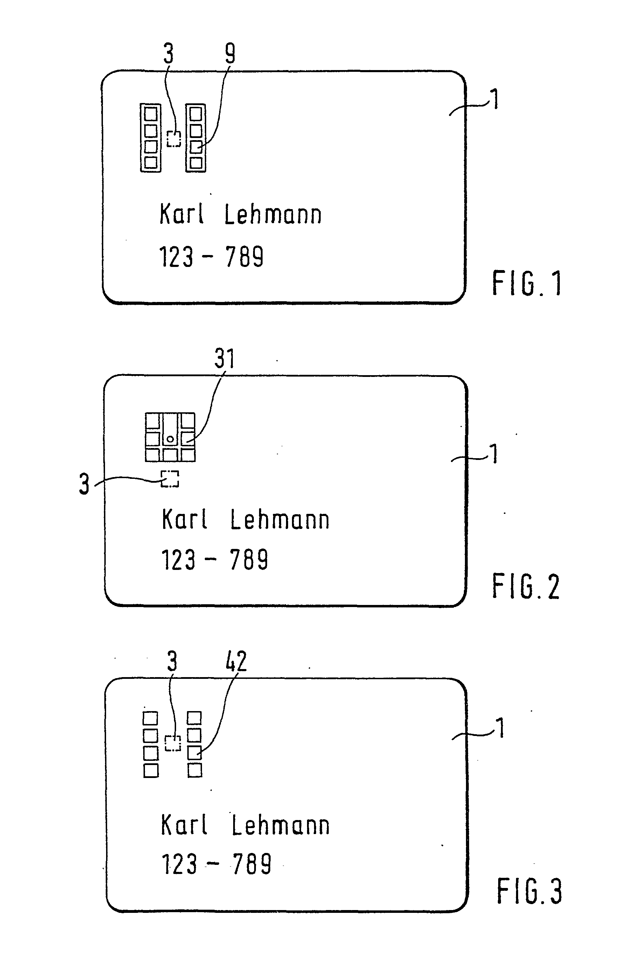

Die Fig. 1, 2 und 3 zeigen Ausweiskarten mit einem auf einem Substrat angeordneten integrierten Schaltkreis, wobei jeweils die Lage des IC-Bausteins und der Kontaktflächen sowie die Ausbildung der Aussparungen in der oberen Deckfolie der Karte variieren. Im unteren Bereich der Karte sind beispielsweise der Name des Karteninhabers und eine Kartennummer aufgedruckt. Der Übersichtlichkeit wegen wurde auf die Darstellung weiterer Zeichen und Druckbilder, wie sie bei derartigen Karten üblich sind, verzichtet. Auf die Einzelheiten der in den Fig. 1, 2 und 3 gezeigten Ausweiskarten soll nachfolgend im Zusammenhang mit der Beschreibung der einzelnen Ausführungsformen detailliert eingegangen werden.

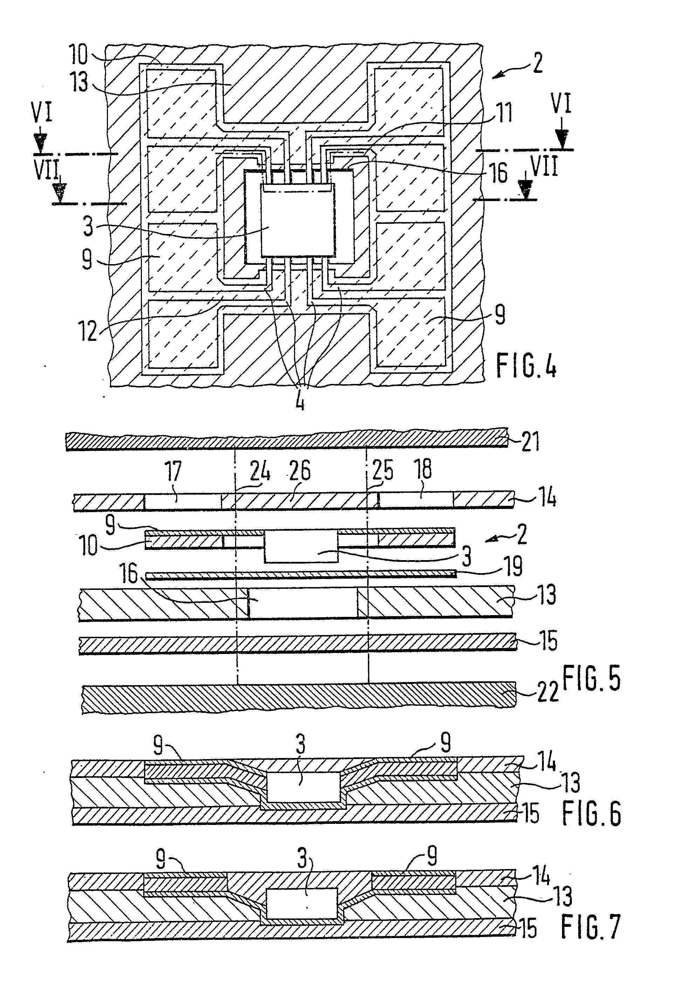

Die Fig. 4, 5, 6 und 7 zeigen eine erste Ausführungsform der Erfindung vor und nach dem Zusammenpressen der einzelnen Kartenschichten. Die fertige Ausweiskarte entspricht der in Fig. 1 gezeigten Karte. Zunächst sei der Aufbau des Trägerelements 2 erläutert, das in der Fig. 4 in der Aufsicht und in der Fig. 5 im Schnitt dargestellt ist. Das Trägerelement 2 besteht aus dem IC-Baustein 3, den Leiterbahnen 4, den Kontaktflächen 9 und dem Substrat 10. Der IC-Baustein 3 ist in einer Aussparung 11 des Substrats 10 mit den in die Aussparung hineinragenden Enden der Leiterbahnen 4 verbunden und wird in dem Fenster lediglich durch die Befestigung der Leiterbahnen mit den entsprechenden Anschlußpunkten des Bausteins gehalten. Diese Art der Befestigung bzw. Bondierung von Halbleiter-Bauelementen mit Leiterbahnen, die aus einer leitenden Beschichtung des Substrats geätzt sind, ist seit langem bekannt und hat sich in der Praxis bewährt (siehe dazu auch Siemens-Bauteile-Report 16 (1978), Heft 2, Seiten 40–44).

Bei dem für die erfindungsgemäße Ausweiskarte verwendetem Trägerelement enden die Leiterbahnen 4 in auf dem Substrat 10 angeordneten Kontaktflächen 9, deren Abmaße so gewählt sind, daß die berührende Kontaktabnahme mit einem geeigneten Abtastkopf in einem Automaten möglich ist. Jeweils 4 Kontaktflächen sind beidseitig des IC-Bausteins 3 in Gruppen zusammengefaßt. Das Substrat 10, das aus flexiblem, thermostabilem und undehnbarem Material, beispielsweise Polyimid besteht, ist derart gestanzt, daß im wesentlichen nur die für die Kontaktflächen und die Leiterbahnen notwendige Fläche durch Filmmaterial unterlegt ist. Die Kontaktgruppen sind über vergleichsweise schmale Substratstege 12 mit dem Substratbereich verbunden, in dem der IC-Baustein angeordnet ist.

Die Fig. 5 zeigt die einzelnen Elemente der Ausweiskarte vor dem Laminieren der Schichten. Die obere Deckfolie 14 hat etwa die Dicke des Substrats 10 einschließlich der Kontaktflächen 9 und ist mit zwei Aussparungen 17, 18 versehen. Die Aussparungen sind so dimensioniert, daß sie jeweils eine Gruppe bestehend aus vier Kontaktflächen aufnehmen können. Die mittlere Kartenschicht oder Kernschicht 13 hat eine Aussparung 16 (siehe dazu auch Fig. 4), die geringfügig größer ist als der IC-Baustein. Die untere Deckfolie 15 schließt die Ausweiskarte rückseitig ab. Wenn, wie in diesem Ausführungsbeispiel gezeigt, das Substrat 10 aus einem Material besteht (beispielsweise aus Polyimid), das sich mit dem Material der Ausweiskarte (beispielsweise PVC), während des Zusammenpressens der Schichten unter Wärme und Druck nicht verbindet, sind geeignete Elemente zur Verbindung der unterschiedlichen Materialien vorzusehen. In diesem Fall kann ein sogenannter Schmelzkleber in Form einer Folie 19 verwendet werden. Mit Hilfe eines solchen Klebers können auch unterschiedliche Kunststoffmaterialien, wie beispielsweise Polyimid und PVC, unter Einwirkung von Wärme und Druck dauerhaft miteinander verklebt werden.

Der in der Fig. 5 gezeigte Schichtaufbau wird, wie bei der Kartenherstellung konventioneller Art üblich, mit Hilfe zweier Stahlplatten 21, 22 unter Einwirkung von Wärme und Druck zusammengepreßt. In der Anfangsphase des Laminierens wirkt sich der Druck der Kaschierplatten vorwiegend auf die Stellen mit der jeweils größten Materialanhäufung im Laminat aus. Es sind dies die durch die strichpunktierten Linien 24, 25 angedeuteten Bereiche, wo jeweils untere Deckschicht 15, Kernschicht 13, Schmelzkleberfolie 19, Substrat 10 und obere Deckschicht 14 übereinanderliegen. Aufgrund dieser Druckverteilung sind der IC-Baustein 3 und die Anschlußpunkte der Leiterbahnen 4 mit dem IC-Baustein zunächst entlastet. Im weiteren Verlauf des Laminierens erweicht die Schmelzkleberfolie und paßt sich dabei formschlüssig der durch IC-Baustein 3, Leiterbahnen 4 und Substrat 10 gebildeten geometrischen Struktur an. Nachfolgend erweichen auch die Kartenschichten. Da das Material des Substrats 10 im Bereich der Laminartemperaturen nicht erweicht, wird es an den durch die Linien 24, 25 angedeuteten Stellen unter Verdrängung des erweichenden Kartenmaterials zwischen Kernfolie 13 und oberer Deckfolie 14 eingebettet. Der IC-Baustein 3 wird, verursacht durch den zwischen den Aussparungen 17, 18 liegenden Steg 26 der Deckfolie 14, in die Aussparung 16 der Kernfolie 13 gedrückt, während die mit den Kontaktflächen 9 versehenen Teile des Substrats 10 in die Aussparungen 17 und 18 der oberen Deckfolie 14 ausweichen. Während dieser Phase, in der schließlich auch die Aussparung 16 der Kernfolie nahezu vollständig mit Kartenmaterial ausgefüllt wird, bietet die sehr weiche Schmelzkleberfolie 19 eine schützende Pufferzone für den IC-Baustein 3 und für die Anschlußleitungen 4.

Die Fig. 6 und 7 zeigen die fertige Ausweiskarte. Fig. 6, eine Schnittzeichnung entlang der Linie 6–6 der Fig. 4, zeigt anschaulich die Verformung des Substrats 10, die dazu führt, daß der IC-Baustein 3 geschützt in der Kartenmitte liegt, während die Kontaktflächen 9 bündig mit der Oberfläche der Karte abschließen. Vor allem im Bereich der Kontaktflächen 9 sorgt der Schmelzkleber 19 nach dem Erkalten des Laminats für eine sichere Haftung des Substrats 10 mit der Karte.

Die Fig. 7, eine Schnittzeichnung entlang der Linie 7–7 der Fig. 4, zeigt, daß obere Deckfolie 14 und Kernfolie 13 durch die so groß wie möglich ausgebildete Aussparung 11 des Substrats 10 hindurch miteinander verbunden sind, so daß die obere Deckfolie 14 auch in der Umgebung des IC-Bausteins 3 fest mit dem Kartenkern verbunden ist. Die bereits erwähnten relativ schmalen Verbindungsstege 12 zwischen den jeweiligen Kontaktgruppen und dem Substratbereich, in dem sich der IC-Baustein befindet, erleichtern die Deformierung des Substrats.

Im folgenden wird eine Karte bzw. der Einbau eines Trägerelements in eine Karte, wie sie bereits in Fig. 2 gezeigt wurde, beschrieben. Bei dieser Ausführungsform befinden sich alle Kontaktflächen auf einer Seite des Substrats, während der IC-Baustein auf der anderen Seite angeordnet ist. In diesem Fall können beispielsweise dickere IC-Bausteine in dem bei Ausweiskarten für Hochprägungen vorgesehenen Bereich angeordnet werden, während die Kontaktflächen an üblicher Stelle plaziert werden, um den für Prägungen vorgesehenen Bereich möglichst wenig zu beanspruchen.

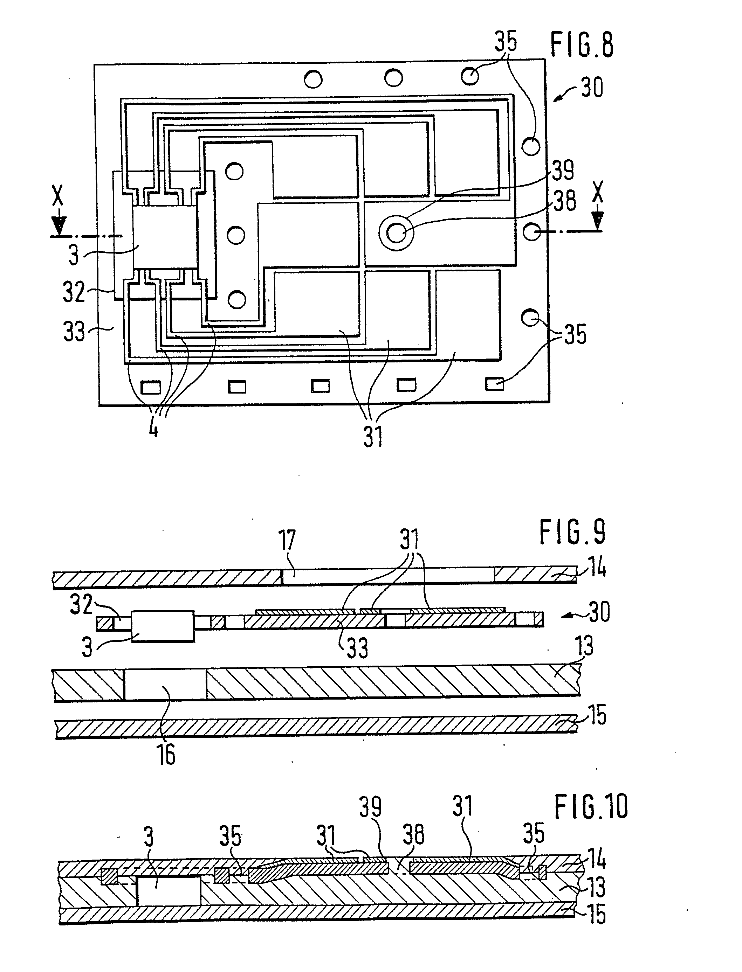

Die Fig. 8 zeigt ein Trägerelement 30 in Aufsicht, bei dem der IC-Baustein 3 und die Kontaktbereiche 31 räumlich getrennt sind. Der IC-Baustein ist in einer Aussparung 32 des Substrats 33 angeordnet und wird durch freitragende Leiterbahnen 4 in dieser Aussparung gehalten. Die Leiterbahnen verbinden den IC-Baustein 3 mit den Kontaktflächen 31. Die Anzahl und die Anordnung der Kontaktflächen richtet sich nach dem verwendeten IC-Baustein und kann an die jeweiligen Bedürfnisse angepaßt werden. In Fig. 8 ist beispielhaft eine Ausführung mit 8 Kontaktbereichen dargestellt. Über das Substrat 33 verteilt sind in Fig. 8 mehrere kleine Löcher 35, 38 erkennbar, die zur Verankerung des Substrats zwischen den einzelnen Kartenfolien dienen.

Fig. 9 zeigt das beschriebene Trägerelement 30 sowie die drei Kartenschichten vor dem Zusammenbau in einer Schnittdarstellung entlang der Linie 10–10 der Fig. 8. Die Kernfolie 13 weist im Bereich des IC-Bausteins 3 eine Aussparung 16 auf, deren Umriß nahezu dieselbe Größe hat wie die Aussparung 32 des Substrats. Die obere Deckfolie besitzt eine Aussparung 17 im Bereich der Kontaktflächen, wobei diese Aussparung kleiner ist als die die Kontaktflächen 31 tragende Substratfläche. Durch das Zusammenpressen unter Einwirkung von Wärme wird das Trägerelement 30, wie in der Fig. 10 dargestellt, derart verformt, daß die die Kontaktflächen tragenden Substratflächen relativ zum IC-Baustein in Richtung zur Oberfläche der Karte hin versetzt ist, so daß der IC-Baustein 3 geschützt durch die beiden Kartendeckfolien 14, 15 in der Mitte der Karte liegt, während die Kontaktflächen 31 bündig mit der Kartenoberfläche abschließen. Es hat sich überraschenderweise gezeigt, daß die Kernfolie 13 einerseits die Randbereiche des Substrats einbettet und andererseits die Kontaktbereiche durch die Aussparung 17 zur äußeren Oberfläche des Schichtaufbaues hochdrückt.

Da das Substrat im Bereich der Kontaktflächen einen gegenüber der Aussparung 17 in der oberen Deckfolie 14 großen Umriß aufweist, sind die Randbereiche des Substrats zwischen oberer Deckfolie 14 und Kernschicht 13 verankert. In Bereichen des Substrats, die keine Kontaktflächen aufweisen, beispielsweise der in Fig. 10 gezeigte linke Teil, ist das Substrat ohnehin zwischen Kern- und oberer Deckfolie eingebettet.

Der IC-Baustein ist in der fertigen Karte in die Aussparung 16 der Kernfolie 13 nach unten verschoben. Die für diese Lageänderung benötigte Dehnung der Leiterbahnen 4 wird durch die im Bereich der Aussparung 32 vorgesehene über Eck-Führung abgefangen.

Weiterhin ist aus Fig. 10 ersichtlich, daß im Bereich der Löcher 35 thermoplastisches Material der Kernfolie 13 und der oberen Deckfolie 14 eingeflossen ist und sich verbunden hat. Durch diese innige Verbindung wird das dazwischenliegende Trägerelement fest in dem Kartenverbund verankert. Durch das Loch 38 im Bereich der Kontaktfläche fließt aufgrund der Druckeinwirkung ebenfalls Material der Kernschicht 13, bis es bündig mit der Kontaktoberfläche abschließt. Da die Aussparung 39 der metallischen Kontaktfläche größer als das Loch 38 im Substrat ist, bildet sich ein im Schnitt T-förmiger Pfropfen, der das Substrat im Kontaktflächenbereich zusätzlich mit der Kernfolie verbindet. Diese Ausführung ist besonders vorteilhaft, wenn der Kontaktbereich großflächig ist.

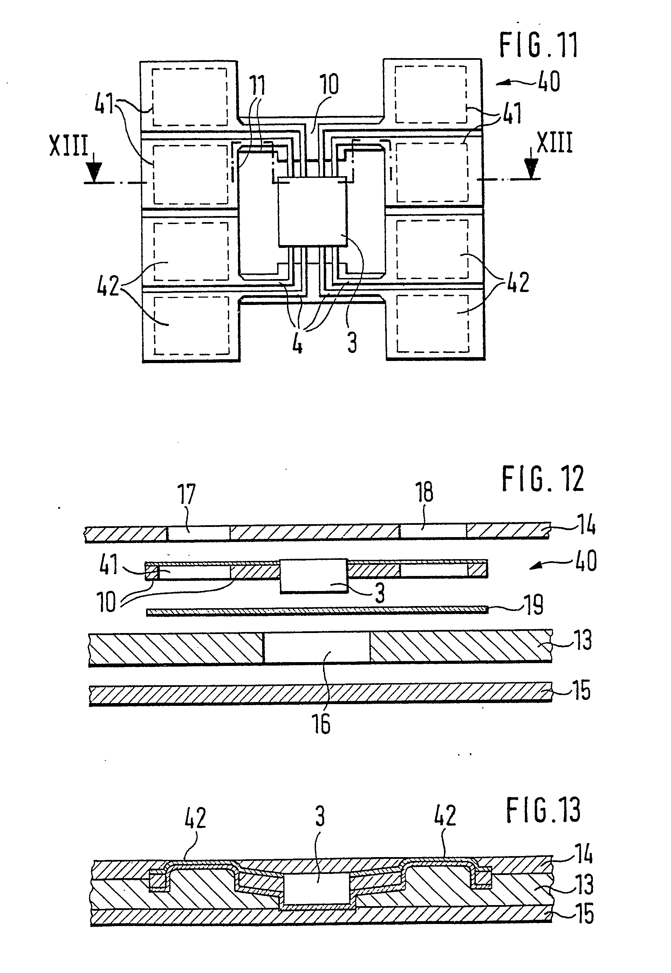

Die Fig. 11 zeigt ein für diese Ausführungsform bevorzugt geeignetes Trägerelement 40. Es gleicht dem in Fig. 4 ausführlich beschriebenen Trägerelement in vielen Punkten. So ist beispielsweise der IC-Baustein 3 in einer Aussparung 11 des Substrats 10 angeordnet und über Leiterbahnen 4 mit den Kontaktflächen 42 verbunden. Einziger Unterschied ist, daß die metallischen Kontaktflächen 42 nicht vollständig von dem Substrat 10 unterlegt sind. Die gestrichelten Linien 41 deuten die im Substrat vorgesehenen Aussparungen unter den jeweiligen Kontaktflächen an.

Fig. 12 zeigt das Trägerelement 40 in Schnittdarstellung entlang der in Fig. 11 eingezeichneten Linie 13–13 vor dem Einbau in die Karte zusammen mit den drei Kartenfolien. Kernfolie 13 und obere Deckfolie 14 weisen die bereits bekannten Aussparungen zur Aufnahme des IC-Bausteins bzw. der Kontaktflächen auf. Für die beschriebene Ausführungsform ist es zweckmäßig, das Trägerelement 40 vor dem Einbau in die Karte mit einer Kleberschicht 19 zu unterlegen. Die Eigenschaften dieser Kleberschicht wurden bereits weiter oben ausführlich beschrieben.

Nach dem Erweichen der Kernschicht 13 wird das Substrat 10 im Bereich des IC-Bausteins 3 zur Kartenmitte hin verformt, während das thermoplastische Kartenmaterial in die Aussparungen 17, 18 der oberen Deckfolie ausweicht. Dabei werden die metallischen Kontaktflächen 42 durch das Kernmaterial zur Oberfläche hin verformt.

Die mit der Verformung verbundene Dehnung wird von den als dünne Metallschichten ausgebildeten Kontaktflächen 42 ausgeglichen. Falls die Kontaktflächen die Dehnung nicht ausgleichen können, beispielsweise bei Verwendung einer relativ dicken Deckfolie, muß dafür gesorgt werden, daß die Längendehnung auf andere Weise kompensiert wird. Beispielsweise kann man die Verbindung der metallischen Kontaktflächen 42 mit dem Substrat 10 im Randbereich des Trägerelements so ausführen, daß sich diese bei Zugbeanspruchung löst, wodurch die metallischen Kontaktflächen an einer oder mehreren Seiten frei bewegbar sind.

Eine weitere Ausführungsform besteht darin, das Substrat 10 über mehrere Kontaktflächen 42 großflächig auszusparen. So können beispielsweise die Kontaktbereiche des in Fig. 11 dargestellten Trägerelements 40 nur an den äußeren bzw. dem IC-Baustein zugewandten Längsseiten mit schmalen Streifen aus Substratmaterial unterlegt sein, um das gleiche Ergebnis zu erzielen, wie bei der oben beschriebenen Form.

Für Anwendungsfälle, in denen das Aufbringen des Schmelzklebers, das üblicherweise unter Wärmeeinwirkung stattfindet, unerwünscht oder unmöglich ist, kann anstelle des Schmelzklebers ein Material in Form einer Folie oder Folienstücken mit Hilfe eines bei Raumtemperatur wirksamen Klebers mit dem Substrat verbunden werden. Dieses Folienmaterial ist so gewählt, daß es beim Laminieren unter Druck- und Wärmeeinwirkung mit dem Kartenmaterial eine innige Verbindung eingeht. Vorzugsweise wird das gleiche Material gewählt, das auch für den restlichen Schichtaufbau verwendet wurde, beispielsweise PVC. Ein Vorteil dieser Art von Verbindung zwischen Substrat und Kartenschichten ist, daß im Bereich des Trägerelements, die beim Laminieren verformt werden sollten, durch gezielte Auftragung des Folienmaterials die Verformung des Trägerelements wirkungsvoll unterstützt werden kann.

Das beschriebene Trägerelement unterliegt sowohl bei der Herstellung des Datenträgers als auch beim Gebrauch desselben unterschiedlichen mechanischen Belastungen.

Die beim Kaschieren auf das Trägerelement einwirkenden Belastungen treten in erster Linie in den Bereichen des Trägerelementes auf, die während des Kaschiervorganges verformt bzw. deformiert werden. Für die spätere Funktion des Datenträgers können sich dabei insbesondere die auf den IC-Bausteinen oder die auf die Leiterbahnen einwirkenden mechanischen Kräfte negativ bemerkbar machen.

Die während der Kartenherstellung auf den IC-Baustein einwirkenden Belastungen werden erfindungsgemäß dadurch abgefangen, daß die während der Kaschierung vorliegenden Druckbelastungen durch Anordnung in einem Hohlraum des Schichtaufbaus vom IC-Baustein ferngehalten werden, so daß zumindest vor Erweichung des Kartenmaterials am IC-Baustein keine direkten Druckbelastungen anliegen.

Die auf die zwischen IC-Bausteinen und Kontaktflächen vorgesehenen Leiterbahnen wirkenden mechanischen Belastungen sind ebenfalls durch besondere Schutzmaßnahmen vor Zug- und Deformationskräften geschützt, in dem die während des Kaschiervorganges deformierten Bereiche der Leiterbahnen durch thermostabile zugfeste Materialien derart unterlegt und mit diesen fest verbunden sind, daß die während der Verformung auftretenden Kräfte von den empfindlichen Leiterbahnen ferngehalten bzw. vom Verstärkungsmaterial abgefangen werden. Die im Bereich der Substrataussparung nicht mit Substrat unterlegten Leiterbahnbereiche werden während des Kaschiervorganges durch einen Streifen der Deckfolie in einer stabilen Lage gehalten, so daß in diesem Bereich die Deformationskräfte relativ gering gehalten werden.

Wie umfangreiche Versuche zeigten, sind die beim Gebrauch der Datenträger vorliegenden mechanischen Belastungen vorwiegend auf Biegebeanspruchungen in Kartenlängs- oder Diagonalrichtung zurückzuführen. Die in Richtung der Kartenbreite wirkenden Biegebelastungen sind demgegenüber weniger von Bedeutung. Eine Beschädigung des Trägerelementes wird bei der erfindungsgemäßen Ausführungsform dadurch verhindert, daß zumindest die in Richtung der Hauptbelastungsachsen verlaufenden, d.h. die in Kartenlängs- oder Diagonalrichtung verlaufenden Leiterbahnen vollständig mit thermostabilem und zugfestem Folienmaterial unterlegt und mit diesem fest verbunden sind. Die Bereiche der Zuleitungen, die nicht mit Substrat unterlegt sind, sind vorzugsweise parallel bzw. entlang der kurzen Kanten des Datenträgers an die Kontaktierungspunkte des IC-Bausteins herangeführt.

Je nach dem, für welche Anwendungszwecke der Datenträger hergestellt wird, können durch spezielle Ausbildung des Trägerelementes bzw. durch die spezielle Gestaltung des Substrats und durch die Anordnung der Kontaktflächen der Leiterbahnen und des IC-Bausteins auf dem Substrat die verschiedenen Belastungsarten gezielt berücksichtigt werden. Bei einem wie in Fig. 4 oder Fig. 11 dargestellten Trägerelement, das gemäß der Darstellung von Fig. 1 oder Fig. 3 in dem Datenträger eingebettet ist, sind so beispielsweise sowohl die bei der Herstellung als auch die beim Gebrauch der Karte auftretenden mechanischen Belastungen berücksichtigt. Ein derartiger Aufbau empfiehlt sich insbesondere bei Datenträgern, die über längere Zeiträume besonders starken mechanischen Belastungen unterworfen werden.

Das in Fig. 8 dargestellte und entsprechend Fig. 2 im Datenträger eingebaute Trägerelement berücksichtigt demgegenüber in erster Linie die bei der Kartenherstellung auftretenden Belastungen. Ein derartiger Aufbau kann, beeinflußt durch verschiedene Randbedingungen, wie z.B. das Vorsehen eines Magnetstreifens auf der Kartenrückseite, besonders sinnvoll sein. Er ist insbesondere dann unbedenklich, wenn der Datenträger im späteren Gebrauch durch kürzere Laufzeit oder sorgsamere Behandlung weniger starken Belastungen ausgesetzt ist.

## Patentansprüche

1. Mehrschichtiger Datenträger, bestehend aus
– mindestens einer Kernschicht sowie einer oberen und unteren Deckschicht,
– einen IC-Baustein für die Verarbeitung elektrischer Signale und
– Kontaktflächen sowie Leiterbahnen zur Verbindung des IC-Bausteins mit externen Geräten,
– einem flexiblen, folienähnlichen Substrat mit einer Aussparung für den IC-Baustein,
wobei IC-Baustein, Kontaktflächen und Leiterbahnen gemeinsam auf dem Substrat angeordnet sind, die Kontaktflächen und Leiterbahnen aus einer dünnen elektrisch leitenden Beschichtung des Substrats hergestellt sind und das Substrat derart zwischen Kern- und Deckschichten eingelagert ist, daß

– der IC-Baustein in einer Aussparung der Kernschicht liegt und

– die Kontaktflächen in wenigstens einer Aussparung der oberen Deckschicht vorliegen, dadurch gekennzeichnet, daß

– das Substrat im Datenträger derart verformt vorliegt, daß die Kontaktflächen bündig mit der Oberfläche des Datenträgers abschließen und der IC-Baustein in einer mittleren Ebene des Datenträgers liegt und daß

– die Leiterbahnen zwischen den Kontaktflächen und dem IC-Baustein nur in den durch Substrat unterlegten Bereichen in die mittlere Ebene gebogen sind.

2. Datenträger nach Anspruch 1, dadurch gekennzeichnet, daß

– mehrere Kontaktflächen in Gruppen zusammengefaßt sind,

– sowohl die Bereiche des Substrats, die die Kontaktgruppen tragen als auch die Aussparungen der oberen Deckschicht an die Umrisse der Kontaktgruppen angepaßt sind.

3. Datenträger nach Anspruch 1 oder 2, dadurch gekennzeichnet, daß

– die Dicke der oberen Deckschicht gleich oder geringfügig größer als die Dicke des Substrats einschließlich der Kontaktflächen ist und

– die Kontaktgruppen zusammen mit den zugehörigen Substratteilen vollständig in die Aussparungen der Deckschicht gebogen sind.

4. Datenträger nach Anspruch 1 oder 3, dadurch gekennzeichnet, daß die Bereiche des Substrats, die den Kontaktflächen unterlegt sind, im Randbereich der Kontaktflächen über diese hinausstehen und die überstehenden Bereiche zwischen Kernschicht und oberer Deckschicht fixiert sind.

5. Datenträger nach Anspruch 1, dadurch gekennzeichnet, daß sowohl die obere Deckschicht als auch das Substrat im Bereich der Kontaktflächen Aussparungen aufweisen, daß die Kontaktflächen derart verformt sind, daß sie durch die Aussparungen der oberen Deckschicht hindurch mit der Oberfläche der Deckschicht abschließen und der unter den Kontaktflächen von den Aussparungen verbleibende Raum mit Material der Kernschicht ausgefüllt ist.

6. Datenträger nach einem oder mehreren der Ansprüche 1 bis 5, dadurch gekennzeichnet, daß die die Kontaktgruppen tragenden Teile des Substrats mittels eines Schmelzklebers auf der Kernschicht fixiert sind.

7. Datenträger nach einem oder mehreren der Ansprüche 1 bis 6, dadurch gekennzeichnet, daß das Substrat aus einer Folie hoher Thermostabilität und hoher Zugfestigkeit, vorzugsweise aus Polyamid hergestellt ist.

8. Datenträger nach einem oder mehreren der Ansprüche 1 bis 7, dadurch gekennzeichnet, daß die Kontaktgruppen über schmale Substratstege (12) mit dem Substratbereich verbunden sind, in dem der IC-Baustein angeordnet ist.

9. Datenträger nach Anspruch 1, dadurch gekennzeichnet, daß

– der Datenträger rechteckig ist,

– das Substrat im Datenträger derart angeordnet ist, daß die Kontaktreihen parallel zu den kurzen Kanten des Datenträgers verlaufen und

– zumindest die Bereiche der Zuleitungen, die parallel zu den Längskanten der Datenträger verlaufen, vollständig mit Substrat unterlegt und mit diesem fest verbunden sind.

10. Datenträger nach Anspruch 9, dadurch gekennzeichnet, daß die Bereiche der Zuleitungen, die nicht mit Substrat unterlegt sind, vorzugsweise parallel zu den kurzen Kanten des Datenträgers an die Kontaktierungspunkte des IC-Bausteins herangeführt sind.

11. Verfahren zur Herstellung eines mehrschichtigen Datenträgers bestehend aus mindestens einer Kernschicht und einer Deckschicht mit einem Trägerelement bestehend aus einem Substrat, auf dem ein IC-Baustein, Leiterbahnen und Kontaktflächen angeordnet sind, dadurch gekennzeichnet, daß

– das aus einem flexiblen Folienmaterial bestehende Substrat mit den darauf angeordneten Kontaktflächen, Leiterbahnen und dem IC-Baustein derart auf der Kernschicht fixiert ist, daß der IC-Baustein im Bereich einer Aussparung der Kernschicht liegt,

– die obere Deckschicht derart über der Kernschicht positioniert wird, daß die Aussparungen dieser Deckschicht über den auf dem Substrat vorgesehenen Kontaktflächen liegen und

– daß dieser Schichtaufbau unter Druck- und Wärmeeinwirkung miteinander derart verschweißt wird, daß durch Verbiegen des Substrats die Kontaktflächen an die Oberflächen der oberen Deckschicht und der IC-Baustein ins Innere des Sichtaufbaus gedrückt werden.

**Claims**

1. Multi-layer data carrier consisting of

– at least one core layer and an upper and lower covering layer,

– an IC component for processing electrical signals and

– contact surfaces and printed conductors for connecting the IC component to external apparatus

– a flexible, film-like substrate with a recess for the IC component,

– the IC component, contact surfaces and printed conductors all being jointly mounted on the substrate, the contact surfaces and printed conductors being made from a thin, electrically conductive coating of the substrate and the substrate being interposed between the core and covering layers in such a way that

– the IC component is located in a recess in the core layer and

– the contact surfaces are present in at least one recess in the upper covering layer, characterised in that

– the substrate is deformed in the data carrier in such a way that the contact surfaces abut flush on the surface of the data carrier and the IC component is located in a central plane of the data carrier and

— the printed conductors between the contact surfaces and the IC component are bent into the central plane only in the areas with underlying substrate.

2. Data carrier according to claim 1, characterised in that

— a plurality of contact surfaces are assembled in groups,

— both the areas of the substrate which carry the contact groups and the recesses in the upper covering layer are adapted to the contours of the contact groups.

3. Data carrier according to claim 1 or 2 characterised in that

— the thickness of the upper covering layer is the same as or slightly greater then the thickness of the substrate including the contact surfaces and

— the contact groups together with the associated parts of substrate are completely bent into the recesses in the covering layer.

4. Data carrier according to claim 1 or 3, characterised in that those areas of the substrate which underlie the contact surfaces project beyond said surfaces in the edge area thereof and the projecting parts are secured between the core layer and the upper covering layer.

5. Data carrier according to claim 1, characterised in that both the upper covering layer and also the substrate have recesses in the area of the contact surfaces, the contact surfaces are deformed in such a way that they meet the surface of the covering layer through the recesses in the upper covering layer and the space left by the recesses under the contact surfaces is filled with material from the core layer.

6. Data carrier according to one or more of claims 1 to 5, characterised in that those parts of the substrate which carry the contact groups are fixed to the core layer by means of a fusible adhesive.

7. Data carrier according to one or more of claims 1 to 6, characterised in that the substrate is made from a film of high thermostability and high tensile strength, preferably polyamide.

8. Data carrier according to one or more of claims 1 to 7, characterised in that the contact groups are connected to the area of the substrate in which the IC component is mounted via narrow webs (12) of substrate.

9. Data carrier according to claim 1, characterised in that

— the data carrier is rectangular,

— the substrate is arranged in the data carrier so that the contact rows run parallel to the short edges of the data carrier and

— at least those parts of the leads which run parallel to the long edges of the data carrier are fully supported by substrate and fixedly connected thereto.

10. Data carrier according to claim 9, characterised in that those parts of the leads which have no underlying substrate are guided to the contacting points of the IC component preferably parallel to the shortedges of the data carrier.

11. Process for producing a multi-layer data carrier consisting of at least one core layer and a covering layer with a carrier element consisting of a substrate on which are mounted an IC component, printed conductors and contact surfaces, characterised in that

— the substrate consisting of a flexible film material with contact surfaces, printed conductors and the IC component mounted thereon is fixed to the core layer in such a way that the IC component is located in the region of a recess in the core layer,

— the upper covering layer is positioned over the core layer in such a way that the recesses in this covering layer are located above the contact surfaces provided on the substrate and

— the laminar construction is welded together, under the effect of pressure and heat, so that, as a result of the bending of the substrate, the contact surfaces are pressed against the surfaces of the upper covering layer and the IC component is pressed into the interior of the laminar structure.

**Revendications**

1. Support de données à plusieurs couches, composé

— d'au moins une couche intérieure ainsi que d'une couche supérieure et inférieure de recouvrement,

— d'une puce de circuit intégré pour le traitement de signaux électriques, et

— de surfaces de contact ainsi que de rubans conducteurs destinés à relier la puce de circuit intégré à des appareils externes,

— d'un substrat flexible semblable à une feuille et muni d'un évidement pour la puce de circuit intégré,

la puce de circuit intégré, les surfaces de contact et les rubans conducteurs étant disposés ensemble sur un substrat, les surfaces de contact et les rubans conducteurs étant fabriqués à partir d'un mince revêtement électroconducteur du substrat et le substrat étant intercalé entre la couche intérieure et les couches de recouvrement de telle sorte que

— la puce de circuit intégré se trouve dans un évidement de la couche intérieure et

— que les surfaces de contact existent dans au moins un évidement de la couche supérieure de recouvrement,

caractérisé en ce que

— le substrat est disposé dans le support de données en étant déformé de telle sorte que les surfaces de contact se trouvent au ras de la surface du support de données et que la puce de circuit intégré se trouve dans un plan médian du support de données, et que

— les rubans conducteurs entre les surfaces de contact et la puce de circuit intégré ne sont repliés vers le plan médian que dans les zones sous lesquelles se trouve un substrat.

2. Support de données selon la revendication 1, caractérisé en ce que

– plusieurs surfaces de contact sont réunies en groupes,

aussi bien les zones du substrat qui portent les groupes de surfaces de contact que les évidements de la couche supérieure de recouvrement sont adaptés aux profils des groupes de surfaces de contact.

3. Support de données selon la revendication 1 ou 2, caractérisé en ce que

– l'épaisseur de la couche supérieure de recouvrement est égale ou légèrement supérieure à l'épaisseur du substrat y compris les surfaces de contact, et

– les groupes de surfaces de contact sont, avec les parties de substrat correspondantes, repliés entièrement dans les évidements de la couche de recouvrement.

4. Support de données selon la revendication 1 ou 3, caractérisé en ce que les zones du substrat qui sont sous les surfaces de contact dépassent les surfaces de contact dans les zones périphériques de ces dernières et que les zones qui dépassent sont fixées entre la couche intérieure et la couche supérieure de recouvrement.

5. Support de données selon la revendication 1, caractérisé en ce que aussi bien la couche supérieure de recouvrement que le substrat présentent des évidements dans la zone des surfaces de contact, en ce que les surfaces de contact sont déformées de telle sorte qu'elles traversent les évidements de la couche supérieure de recouvrement et se terminent au ras de la surface de la couche de recouvrement et que l'espace exempt d'évidements sous les surfaces de contact est rempli de matériau de la couche intérieure.

6. Support de données selon l'une quelconque des revendications 1 à 5, caractérisé en ce que les parties du substrat portant les groupes de surfaces de contact sont fixées sur la couche intérieure à l'aide d'une colle à fusion.

7. Support de données selon l'une quelconque des revendications 1 à 6, caractérisé en ce que le substrat est fabriqué à partir d'une feuille de stabilité thermique et de résistance à la traction élevées, en polyamide, par exemple.

8. Support de données selon l'une quelconque des revendications 1 à 7, caractérisé en ce que les groupes de surfaces de contact sont reliés par des bandes étroites de substrat (12) à la zone de substrat dans laquelle est disposée la puce de circuit intégré.

9. Support de données selon la revendication 1, caractérisé en ce que

– le support de données est rectangulaire,

– le substrat est disposé dans le support de données de telle sorte que les rangées de contact s'étendent parallèlement aux bords courts du support de données, et

– le substrat se trouve entièrement au moins sous les zones des fils d'amenée qui s'étendent parallèlement aux bords longitudinaux du support de données et est relié de manière fixe auxdites zones.

10. Support de données selon la revendication 9, caractérisé en ce que les zones des fils d'amenée sous lesquelles il n'y a pas de substrat, sont amenées de préférence parallèlement aux bords courts du support de données vers les points de contact de la puce de circuit intégré.

11. Procédé de fabrication d'un support de données à plusieurs couches composé d'au moins une couche intérieure et d'une couche de recouvrement, avec un élément porteur composé d'un substrat sur lequel sont disposés une puce de circuit intégré, des rubans conducteurs et des surfaces de contact, caractérisé en ce que

– le substrat constitué d'un matériau flexible sous forme de feuille est fixé avec les surfaces de contact, les rubans conducteurs et la puce de circuit intégré qu'il comporte, sur la couche intérieure de telle sorte que la puce de circuit intégré se trouve dans la zone d'un évidement de la couche intérieure,

– la couche supérieure de recouvrement est positionnée au-dessus de la couche intérieure de telle sorte que les évidements de cette couche de recouvrement se trouvent au-dessus des surfaces de contact prévues sur le substrat, et

– les couches de cette structure sont soudées entre elles sous l'action de la pression et de la chaleur, que par courbure du substrat, les surfaces de contact sont pressées sur la surface de la couche supérieure de recouvrement et la puce de circuit intégré vers l'intérieur de la structure de couches.

Karl Lehmann
123 – 789

FIG.1

Karl Lehmann
123 – 789

FIG.2

Karl Lehmann
123 – 789

FIG.3

FIG.4

FIG.5

FIG.6

FIG.7

FIG.8

FIG.9

FIG.10

FIG.11

FIG.12

FIG.13